# EUROPEAN PATENT APPLICATION

(11) **EP 4 812 008 A1**
(43) Date of publication of application: **23.09.2026**
(21) Application number: 26165453.7
(22) Date of filing: 17.03.2026
(51) Int. Cl.: H10W 70/40, H10W 40/25, H10W 90/00, H10W 70/60, H10D 84/08, H10D 84/83, H10W 40/77, H10W 72/30

(54) **PACKAGED ELECTRONIC DEVICE COMPRISING A HORIZONTAL CONTACT CONFIGURATION COMPONENT AND A VERTICAL CONTACT CONFIGURATION COMPONENT**

(30) Priority: 20.03.2025 IT 202500005736
(71) Applicant: STMicroelectronics International N.V., 1228 Plan-les-Ouates, Geneva (CH)
(72) Inventor: STELLA, Cristiano Gianluca, 20864 Agrate Brianza (MB) (IT); MESSINA, Sebastiano, 20864 Agrate Brianza (MB) (IT); TORRISI, Marco, 20864 Agrate Brianza (MB) (IT)
(74) Representative: Studio Torta S.p.A.

(57) **Abstract**

Packaged electronic device having a first and a second dice arranged between a first and a second support element (75, 76) formed by multilayers. The first die (60) has a first and a second contact region (64, 64) on its first main face (60A). The second die (61) has a first contact region (69) on its first main face (61A) and a second contact region (71) on its second main face (61B). The dice (60, 61) are bonded with their first face (60A, 61A) to the second support element (76) and with their second face (60B, 61B) to the first support element (75). The first support element (75) forms a conductive interconnection region (80) electrically coupled to the first contact region (69) of the second die (61). The second support element (76) forms a plurality of islands, including a first island (89G) coupled to the first contact region (64) of the first die (60) through an internal portion (87G) of a first connection element (88G); a second island (89D) coupled to the first contact region (69) of the second die (61) through the internal portion (87D) of a second connection element (88D). A third connection element (88C) couples the second contact region (65) of the first die (60) to the interconnection region (80).

## Description

### Technical Field

The present invention relates to a packaged electronic device comprising a horizontal contact configuration component and a vertical contact configuration component.

For example, the packaged electronic device may comprise a power component capable of providing a high load current (up to 10-15 A) switching at a high frequency (100-400 kHz), for example a gallium nitride (GaN) based device, having horizontal conduction or in any case contact pads arranged on a single main surface, and a low-voltage component, such as a silicon-based MOSFET, having vertical conduction.

In particular, in the following description reference will be made to a packaged electronic device, wherein the horizontal contact configuration component and the vertical contact configuration component are mutually coupled in a cascode configuration.

### Background

Electronic devices including a power component and a low-voltage silicon MOSFET device, coupled in a cascode configuration, are known.

A solution is for example described in "GaN HEMT Improves Overall Performance in ZVS Totem Pole PFC Converters", 2023 IEEE Applied Power Conference and Exposition (APEC) 978-1-6654-7539-6/23, 19-23 March 2023, Marco Torrisi, Sebastiano Messina, Daniele Giovanni Sfilio, Giuseppina Fiore, Giuseppe Di Stefano, Mario Cacciato, which discusses the advantages achievable by using GaN transistors having wide bandgap and high switching frequency, which allows to obtain the reduction of switching losses compared to separate components and to other solutions using superjunction MOSFETs.

In this solution, the two devices are each integrated into a respective die and packaged in a housing having a through hole.

Despite the advantages of this solution, it is susceptible to improvement for obtaining right creepage distances (safety distances) in case of high power consumption operation.

US 2024/355724 A1 discloses a packaged electronic device having multilayer support elements supporting vertical contact configuration components connected to the outside of the package by wires and inner leads.

Other packaged power electronic devices are disclosed by US 2007/216013 A1, US 2013/181228 A1, US 11 211 373B1, US 2021/391236 A1, US 5 539 254A and CN 116 525 588 A.

The aim of the present invention is to improve the performance of known devices.

### Summary

According to the present invention, a packaged electronic device and a packaging method are provided, as defined in the attached claims.

### Brief Description of the Drawings

For a better understanding of the present invention, an embodiment thereof is now described, purely by way of nonlimiting example, with reference to the attached drawings, wherein:
- Figure 1 shows the electrical diagram of an embodiment of the present power device, here formed by the cascode connection of a GaN transistor and a low-voltage MOSFET;
- Figure 2 shows, in cross-section, part of the GaN transistor and the low-voltage MOSFET of Figure 1, integrated in respective dice, and the related electrical connections;
- Figure 3 is a top perspective view of the present power device;
- Figure 4 is a bottom perspective view of the present power device;
- Figure 5 is a top view of the die integrating the GaN transistor of Figure 2 and showing the contact regions thereof;
- Figure 6 is a top view of the die integrating the low-voltage MOSFET of Figure 2 and showing the contact pads thereof;
- Figure 7A is a cross-section, taken along line VIIA-VIIA of Figure 4, of the present power device;
- Figure 7B is a cross-section, taken along line VIIB-VIIB of Figure 4, of the present power device;
- Figure 8 is a cross-section, taken along line VIII-VIII of Figure 4, of the present power device;
- Figure 9 is a bottom perspective view of a part of the present power device, in an intermediate mounting step;
- Figure 10 shows, in bottom perspective view, a detail of Figure 9;
- Figure 11 is a top perspective view of another part of the present power device, before mounting with the part of Figure 9; and
- Figures 12-14 show a cooled system, comprising a cooling plate and the present power device.

### Description of Embodiments

The following description refers to the arrangement shown; consequently, expressions such as "above", "below", "upper", "lower", "right", "left" relate to the attached Figures and are not to be construed in a limiting manner.

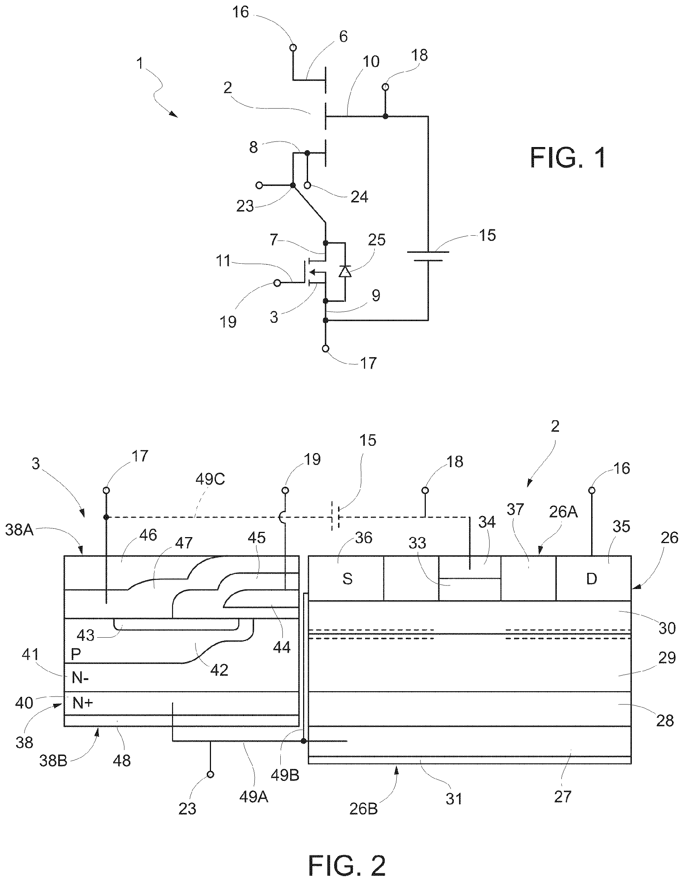

Figure 1 shows an electronic device 1 formed by a first transistor 2, a high-power transistor (here a GaN MOSFET) and a second transistor 3, a low-voltage transistor (having a lower voltage than the first transistor 2), coupled in a cascode configuration.

In detail, the first and second transistors 2, 3 have each a first conduction terminal 6, respectively 7 (drain terminal); a second conduction terminal 8, respectively 9 (source terminal) and a control terminal 10, respectively 11 (gate terminal).

The second conduction terminal 8 of the first transistor 2 is coupled to the first conduction terminal 7 of the second transistor 3; and the control terminal 10 of the first transistor 2 is coupled to the second conduction terminal 9 of the second transistor 3 through a voltage generator 15, which is external.

Furthermore, the first conduction terminal 6 of the first transistor 2 is coupled to a first output conduction terminal 16 of the electronic device 1; the second conduction terminal 9 of the second transistor 3 is coupled to a second output conduction terminal 17 of the electronic device 1; the control terminal 10 of the first transistor 2 is coupled to a first output control terminal 18 of the electronic device 1; and the control terminal 11 of the second transistor 3 is coupled to a second output control terminal 19 of the electronic device 1.

Furthermore, in the electronic device 1 of Figure 1, the second conduction terminal 8 of the first transistor 2 and the first conduction terminal 7 of the second transistor 3 are coupled to an intermediate output terminal 23 of the electronic device 1; and the second conduction terminal 8 of the first transistor 2 is also coupled to an output verification terminal 24 (auxiliary or "kelvin" source terminal) of the electronic device 1.

Furthermore, Figure 1 shows a parasitic diode 25 anti-series coupled to the second transistor 3.

In the electronic device 1 of Figure 1, the first transistor 2 is a horizontal contact configuration component and the second transistor 3 is a vertical contact configuration component, which may be implemented for example as shown in Figure 2.

In detail, with reference to Figure 2, the first transistor 2 is formed in a first die 26 having a first face 26A and a second face 26B and comprising a substrate 27, a buffer layer 28, a first semiconductor layer 29 and a second semiconductor layer 30, mutually superimposed.

The substrate 27 may be of, for example, monocrystalline silicon; the buffer layer 28, directly superimposed on and in contact with the substrate 27, may be of, for example, one or more AlGaN/GaN/AlN alloys; the first semiconductor layer 29, for example directly superimposed on and in contact with the buffer layer 28, may be of a first semiconductor alloy of elements of the groups III and V of the periodic table, for example gallium nitride (GaN); and the second semiconductor layer 30, for example directly superimposed on and in contact with the first semiconductor layer 28, may be of a second semiconductor alloy, different from the first semiconductor alloy, of elements of the groups III and V of the periodic table, for example aluminum gallium nitride (AlGaN).

A substrate metallization layer 31 extends on the substrate 27. The substrate metallization layer 31 defines the second face 26B of the die 26.

The first semiconductor layer 29 forms, in its upper part, a channel layer, and the second semiconductor layer 30 forms a barrier layer.

The first semiconductor layer 29 and the second semiconductor layer 30 are for example of N-type.

A GaN gate region 33 extends above the second semiconductor layer 30. The GaN gate region 33 is of conductive material, for example of a third semiconductor alloy, different from the first and second semiconductor alloys, of elements of the groups III and V of the periodic table, for example of P-type gallium nitride (p-GaN).

A gate electrode 34, of metal, is arranged above and in direct electrical contact with the GaN gate region 33, forms the control terminal 10 of the first transistor 2 of Figure 1 and is coupled to the first output control terminal 18 of the electronic device 1.

A drain electrode 35 and a source electrode 36 are arranged above and in contact with the second semiconductor layer 30, on opposite sides of the GaN gate region 33, and form the conduction terminals 6, 8 of the first transistor 2 of Figure 1, coupled to the first output conduction terminal 16 and, respectively, to the intermediate output terminal 23 of the electronic device 1.

All the electrodes 34-36 of the first transistor 2 here face the first face 26A of the first die 26, electrically insulated from each other, for example by a first dielectric layer 37.

The second transistor 3 is formed in a second die 38 (shown only in part in Figure 2) having a first and a second face 38A, 38B and comprising a substrate 40 and an epitaxial layer 41 superimposed on the substrate 40 of the second die 38.

A body region 42 extends in the epitaxial layer 41; a source region 43 is surrounded by the body region 42; a MOSFET gate region 44 is superimposed on the epitaxial layer 41; and an oxide layer 45 surrounds the MOSFET gate region 44.

The second die 38 also comprises a source metallization 47 superimposed on the epitaxial layer 41 and the oxide layer 45 and surrounded by a second dielectric layer 46; and a drain metallization 48, below the substrate 40.

Here, the MOSFET gate region 44 is coupled to a respective gate metallization, represented only schematically by the second output control terminal 19. Furthermore, the source metallization 47 is coupled to the second output conduction terminal 17 of the electronic device 1 of Figure 1.

For example, the source metallization 47 faces the first face 38A of the second die 38; the drain metallization 48 forms the second face 38B of the second die 38.

Figure 2 also schematically shows a first connection 49A between the substrate 27 of the first transistor 2 and the substrate 40 of the second transistor 3 and a second connection 49B between the source electrode 36 of the first transistor 2 and the substrates 27, 40 (through the first connection 49A). Figure 2 also shows in dashed line an external connection 49C between the gate electrode 34 of the first transistor 2 and the source metallization 47 of the second transistor 3, through the voltage generator 15.

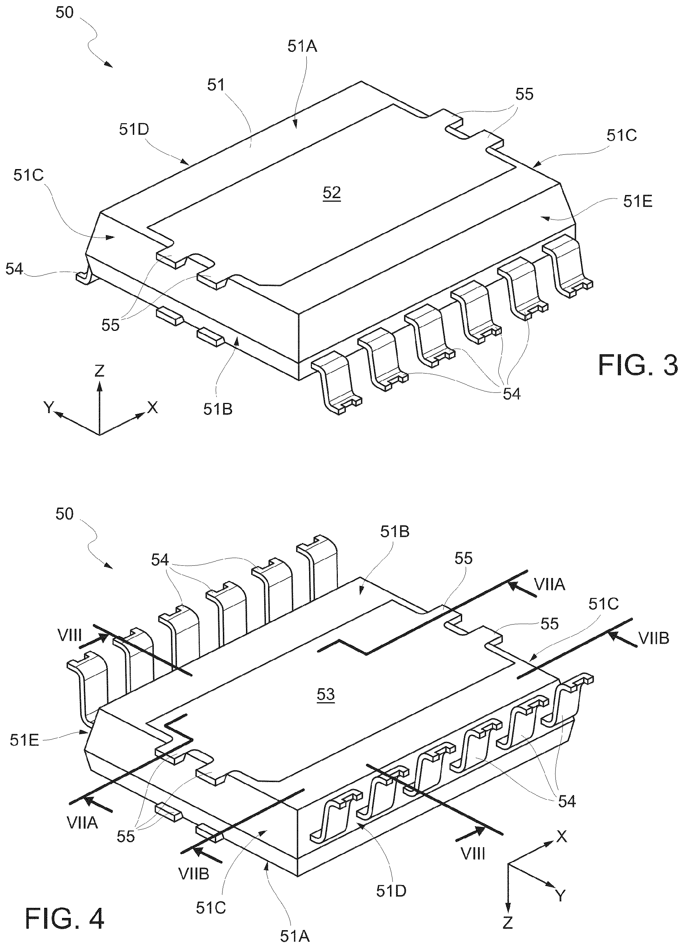

The connections 49A and 49B are described hereinbelow with reference to Figures 3-11, showing a packaged electronic device 50 having double cooling side, suitable for surface mounting, having high creepage and electrically insulated.

In particular, the packaged electronic device 50 comprises a housing 51 generally of parallelepiped shape, having a first main surface 51A, a second main surface 51B, two front surfaces 51C and two lateral surfaces, hereinafter also referred to as the first lateral surface 51D and the second lateral surface 51E.

In the example shown, the lateral surfaces 51D, 51E are longer than the front surfaces 51C; however, the housing 51 might have a generally parallelepiped shape with a square base, with front surfaces 51C and lateral surfaces 51D, 51E of equal length.

Pins, here simply indicated by the number 54 but hereinafter also indicated as pins 54A-54G, when useful to distinguish them, protrude from the lateral surfaces 51D, 51E.

The housing 51 is of insulating material, such as resin, which leaves a first and a second plate 52, 53 exposed on the first and, respectively, the second main surface 51A, 51B.

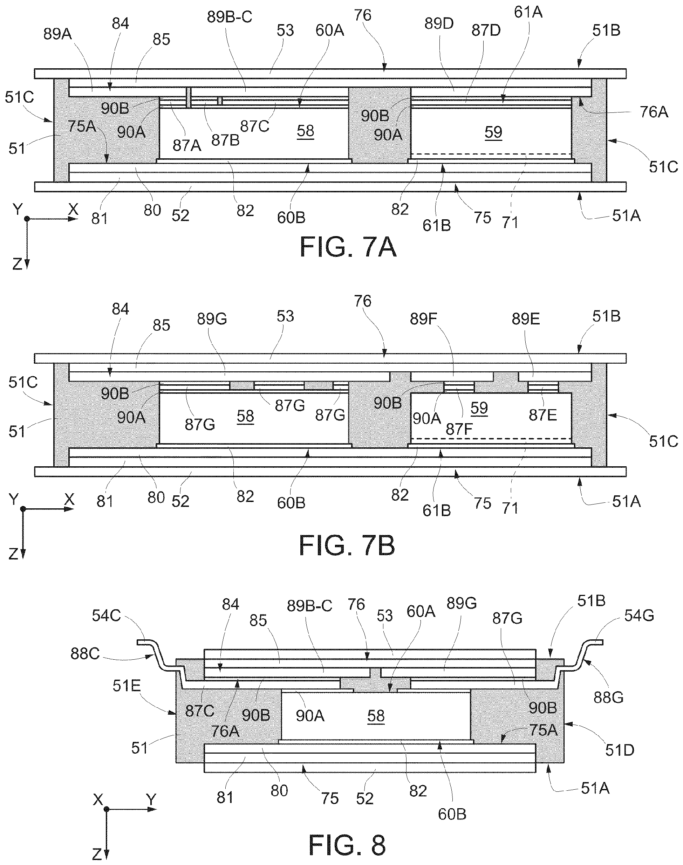

The first and second plates 52, 53 are here slightly protruding with respect to the housing 51, as visible in the section of Figure 8; alternatively they might be level with the respective main surface 51A, 51B.

Furthermore, the plates 52, 53 have fins or tabs 55 protruding from the front surfaces 51C; the pins 54 are folded to form wettable flanks.

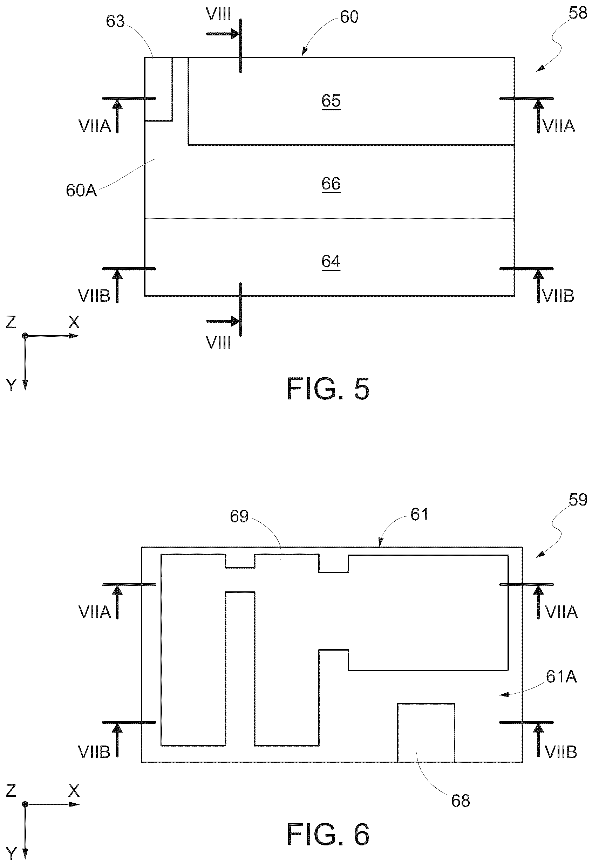

The housing 51 completely embeds a first component, in particular a first transistor 58, having contact regions arranged only on one main face thereof, and a second component, in particular a second transistor 59, having contact regions arranged on both its main faces, as shown in Figures 5, 6.

The first and second transistors 58, 59 are formed in a first and, respectively, a second die 60, 61 that have a generally parallelepiped shape.

For example, the first and second transistors 58, 59 may be formed like the first and second transistors 2 and 3 of Figure 2.

In detail, Figure 5 shows a first face 60A of the first die 60 (e.g., the first face 26A of the first die 26 of Figure 2). The first die 60 also has a second face 60B visible in Figures 7A, 7B and 8.

In particular, Figure 5 shows a control contact region 63 of the first transistor 58 (e.g., the gate electrode 34 of the first transistor 2 of Figure 2), a first current-conduction contact region 64 of the first transistor 58 (e.g., the drain electrode 35 of the first transistor 2 of Figure 2), and a second current-conduction contact region 65 of the first transistor 58 (e.g., the source electrode 36 of the first transistor 2 of Figure 2), surrounded by a passivation layer 66 (e.g., the first dielectric layer 37 of Figure 2).

The contact regions 63-65 of the first transistor 58 may be arranged, for example, as shown in Figure 5, i.e. the second current-conduction contact region 65 and the control contact region 63 of the first transistor 58 may be arranged side by side along a first side of the first die 60 and the first current-conduction contact region 64 of the first transistor 58 may be arranged along an opposite side of the first die 60.

In Figure 5, for illustrative clarity, the section lines VIIA-VIIA, VIIB-VIIB and VIII-VIII of Figure 4 have been shown in the zone where they traverse the first die 60.

Figure 6 shows a first face 61A of the second die 61 (e.g., the first face 38A of the second die 38 of Figure 2). The second die 61 also has a second face 61B visible in Figures 7A and 7B.

In particular, Figure 6 shows a control contact region 68 of the second transistor 59 (e.g., coupled to the MOSFET gate region 44 of the second transistor 3 of Figure 2) and a first current-conduction contact region 69 of the second transistor 59 (e.g., the source metallization 47 of the second transistor 3 of Figure 2). The control contact region 68 and the first current-conduction contact region 69 of the second transistor 59 are electrically separated by a second dielectric layer 46 (e.g., the second dielectric layer 46 of Figure 2).

The second transistor 59 also comprises an own second current-conduction contact region (e.g., the drain metallization 48 of the second transistor 3 of Figure 2), not visible in Figures 6-8, as extending on an opposite face of the second die 61, but represented schematically with a dashed line in Figures 7A and 7B and indicated by 71.

It should be noted that the shape shown of the first current-conduction contact region 69 of the second transistor 59 is complex, but might have other shapes, according to any needs of the designer.

Hereinafter, the connections of the dice 60, 61 in the packaged electronic device 50 will be described, with reference to Figures 7A-11, wherein, for ease of understanding, the first current-conduction contact region 64 of the first transistor 58 is also referred to as the drain contact region 64 of the first transistor 58; the second current-conduction contact region 65 of the first transistor 58 is also referred to as the source contact region of the first transistor 58; the first current-conduction contact region 69 of the second transistor 59 is also referred to as the source contact region 69 of the second transistor 59; and the second current-conduction contact region of the second transistor 59 is also referred to as the drain contact region 71 of the second transistor 59.

With reference to Figures 7A, 7B and 8, the first and second plates 52, 53 are part of a first support 75 and, respectively, of a second support 76, embedded in the material of the housing 51, except for the exposed faces of the plates 52, 53.

In detail, the first support 75 is formed by a multi-layer, electrically insulating and thermally conductive substrate, such as a DBC (Direct Bonded Copper) substrate, including a first conductive layer 80, for example of copper; an intermediate insulating layer 81, for example of ceramic; and a second conductive layer, formed by the first plate 52, for example of copper.

In practice, the first support 75 has an outwardly facing face, largely forming the first main surface 51A of the housing 51 (as indicated above with reference to Figures 3 and 4), and an inwardly facing face 75A, formed by its first conductive layer 80.

The inwardly facing face 75A of the first support 75 defines a support face (and hereinafter also indicated by 75A) having the second faces 60B, 61B of the first and second dice 60, 61 bonded thereto, at a mutual distance, through a first adhesive layer 82, for example a solder paste.

The first conductive layer 80 of the first support 75 is continuous or in any case forms an interconnection region (hereinafter, also indicated by 80) such as to electrically connect lower metallizations of the dice 60, 61 (in the example, the substrate metallization layer 31 of the first transistor 2 and the drain metallization layer 48 of the second transistor 3 of Figure 2), bonded thereto. In this manner, for example, the substrates 27, 40 of Figure 2 are mutually coupled and the first conductive layer 80 forms the first connection 49A of Figure 2.

In other words, in this example of Figure 2, both the substrate 27 of the first die 26 and the substrate 40 of the second die 38 are arranged facing and in electrical contact with the support face 75A of the first support 75.

The second support 76 is also formed by a multi-layer, electrically insulating and thermally conductive substrate, such as a DBC substrate, including a first conductive layer 84, for example of copper; an intermediate insulating layer 85, for example of ceramic; and a second conductive layer, formed by the second plate 53, for example of copper.

In practice, the second support 76 has an outwardly facing face, largely forming the second main surface 51B of the housing 51 (as indicated above with reference to Figures 3 and 4), and an inwardly facing face 76A, formed by the first conductive layer 84.

The inwardly facing face 76A of the second support 76 defines a thermal connection face (and hereinafter still indicated by 76A).

The first and second dice 60, 61 are coupled to the thermal connection face 76A of the second support 76 with the interposition of internal portions 87A-87F of connection elements 88A-88F and of adhesive regions formed in a second and a third adhesive layer 90A, 90B, for example of solder.

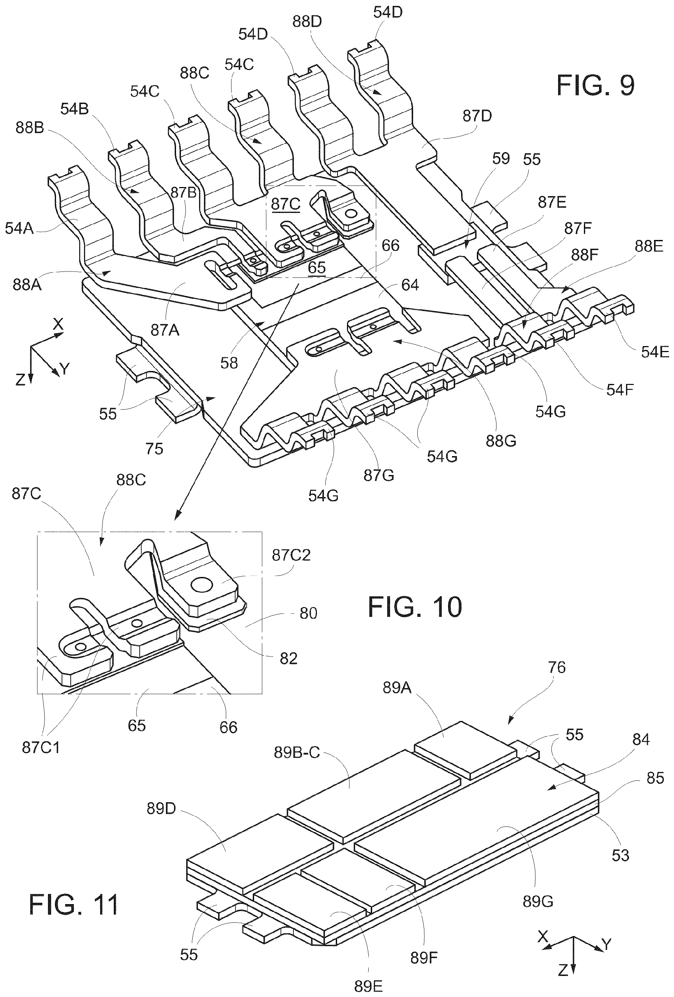

The connection elements 88A-88G (whose internal portions 87A-87G are hereinafter also referred to as clips and generically indicated with the number 87, when it is not necessary to distinguish them) are shown in Figures 9 and 10 and described in detail below.

As shown in Figure 11 and described in detail below, the first conductive layer 84 of the second support 76 is shaped so as to form a plurality of islands 89A, 89B-C, 89D, 89E, 89F and 89G (hereinafter also referred to generically as islands 89, when it is not necessary to distinguish them), for the electrical and thermal connection of the contact regions 64, 65, 68, 69 of the dice 60, 61 (Figures 5 and 6).

In other words, the contact regions 64, 65, 68, 69 of the first and second transistors 58, 59 are electrically coupled to the clips 87 and to the islands 89 through the adhesive regions 90A, 90B.

The mutual arrangement of the first die 60, the second die 61, the connection elements 88A-88G and the first support 75 is visible in Figures 9 and 10, wherein Figure 9 shows, in a bottom perspective view, an intermediate mounting step, when the dice 60, 61 have already been bonded to the first support 75 and the connection elements 88A-88G have already been bonded to the dice 60, 61, but the second support 76, shown in Figure 11, is not yet present. Figure 10 shows an enlarged detail of Figure 9.

In detail, with reference to Figure 9, the connection elements 88A-88G here comprise seven connection elements, identified as first control connection element 88A, first kelvin connection element 88B, first conduction connection element 88C, second conduction connection element 88D, second control connection element 88EF, second kelvin connection element 88FG and second conduction connection element 88G.

In particular, when the dice 60, 61 integrate the first and second transistors 2, 3 of Figure 2, the first control connection element 88A corresponds to the first output control terminal 18 of Figures 1 and 2 (gate terminal 10 of the GaN transistor); the first kelvin connection element 88B corresponds to the output verification terminal 24 of Figures 1 and 2; the first conduction connection element 88C corresponds to the intermediate output terminal 23 (source terminal 8 of the first transistor 2) of Figures 1 and 2; the second conduction connection element 88D corresponds to the second output conduction terminal 17 (source terminal of the second transistor 2) of Figures 1 and 2; the second control connection element 88E corresponds to the second output control terminal 19 (coupled to the control terminal 11 of the second transistor 3) of Figures 1 and 2; the second kelvin connection element 88F is coupled to the source terminal of the second transistor 3 of Figures 1 and 2 (not shown in Figure 1); and the second conduction connection element 88G corresponds to the first output conduction terminal 16 of Figures 1 and 2, coupled to the drain terminal of the first transistor 2.

Each connection element 88A-88G is formed by a shaped flat metal region comprising, as indicated above, a respective clip 87A-87G and at least one respective pin 54A-54G, wherein the letters A-G in the clips 87A-87G and in the pins 54A-54G refer to the respective connection element 88A-88G having the same letter A-G.

In particular, the clips 87A-87G are shaped and arranged so as to contact the upper surfaces (in Figures 7A-10) of the dice 60, 61, in the manner described in detail hereinbelow, and therefore extend in height (parallel to the vertical axis Z of the Cartesian system XYZ) at a distance from the first support 75 (in these figures, represented below the second support 76), in particular, at a distance from the support face 75A of the first support 75. They however, as indicated, are bonded to the first conductive layer 84 of the second support 76 and therefore to the islands 89A, 89B-C, 89D-89G.

In detail, with reference to Figures 5, 7A-9:
the first control connection element 88A has the respective clip 87A (visible in Figure 7A) coupled to the control contact region 63 of the first transistor 58 (and therefore, in the example, to the gate terminal 10 of the GaN transistor 2) and the respective pin 54A intended, after attaching the second support 76 and moulding the resin of the housing 51, to protrude from the second lateral surface 51E of the housing 51 (Figure 4);
the first kelvin connection element 88B and the first conduction connection element 88C have the respective clips 87B, 87C (visible in Figure 7A and, in part, in Figure 9) coupled to the second current-conduction contact region 65 of the first transistor 58 (and therefore, in the example, to the source electrode 36 of the first GaN transistor 2 of Figure 2) and the respective pins 54B, 54C intended to protrude from the second lateral surface 51E of the housing 51;
the second conduction connection element 88D has the respective clip 87D (visible in Figure 7A) coupled to the first current-conduction contact region 69 of the second transistor 59 (and therefore, in the example, to the source metallization 47 of the second transistor 3 of Figure 2) and the respective pin 54D intended to protrude from the second lateral surface 51E of the housing 51;
the second control connection element 88E (visible in Figure 7B) has the respective clip 87E coupled to the control contact region 68 of the second transistor 59 (and therefore, in the example, to the gate terminal 11 of the second transistor 3 of Figure 2) and the respective pin 54E intended to protrude from the first lateral surface 51D of the housing 51;
the second kelvin connection element 88F has the respective clip 87F (visible in Figure 7B) coupled to the first current-conduction contact region 69 of the second transistor 59 (as well as the clip 87D of the second conduction connection element 88D) and the respective pin 54F intended to protrude from the first lateral surface 51D of the housing 51; and
the second conduction connection element 88G has the respective clip 87G (visible in Figures 7B and 9) coupled to the first current-conduction contact region 64 of the first transistor 58 (and therefore, in the example, to the drain electrode 35 of the first GaN transistor 2 of Figure 2) and the respective pin 54G intended to protrude from the first lateral surface 51D of the housing 51.

As shown on an enlarged scale in the detail of Figure 10, the clip 87C of the first conduction connection element 88C has, in addition to the section in contact with the second current-conduction contact region 65 of the first transistor 58 and therefore extending to the same level as the other clips 87A, 87B, 87D-87F (upper section 87C1), a lowered section 87C2 which is bonded to the first conductive layer 80 of the first support 75. Therefore, it forms the second connection 49B between the source electrode 36 of the first transistor 2 and the substrates 27, 40 of Figure 2.

As indicated above, in the electronic device 50 of Figures 3, 4, the islands 89 of the second support 76 are bonded to the clips 87, so that each island 89A, 89B-C, 89D, 89E, 89F and 89G couples with the clips 87A-87G having the same letter A-G, with the particularity that the clips 87B and 87C of the first kelvin connection element 88B and the first conduction connection element 88C are coupled to a single island, indicated by 89B-C.

Alternatively, the island 89B-C might be divided.

In this manner, the islands 89A, 89B-C, 89D, 89E, 89F and 89G form, with the second plate 53, first thermal vias capable of effectively dissipating the heat generated by the flow of current in the contact regions 63-65, 68, 69 of the first and second transistors 58, 59 through the second main surface 51B of the housing 51 (Figure 4).

Conversely, the first conductive layer 80 of the first support 75, bonded to the second faces of the dice 60, 61 (at the bottom in Figures 7A, 7B and 8) forms, in addition to an electrical connection element (first connection 49A of Figure 2, as indicated above), a second thermal via capable of effectively dissipating the heat generated by the flow of current in the substrates of the first and second transistors 58, 59 (27, 40 in the example of Figure 2) through the first main surface 51A of the housing 51.

The electronic device 50 is implemented by providing the first and second supports 75, 76, with the respective first conductive layers 80, 84, where necessary, shaped as explained above.

Then, the second faces 60B, 61B of the dice 60, 61 are bonded to the first conductive layer 80 of the first support 75 through the first adhesive layer 82.

Successively, the second adhesive layer 90A is selectively deposited to ensure the electrical separation of the terminals of the dice 60, 61; then the connection elements 88 are placed and bonded (possibly connected and supported through a leadframe not shown in the manner described above).

After selective deposition of the third adhesive layer 90B, the second support 76 is placed on the clips 87, rotating it around the second horizontal axis Y of the Cartesian system XYZ of Figure 11 and is bonded.

Molding of the housing 51 and usual final operations follow, including dicing the leadframe, if envisaged.

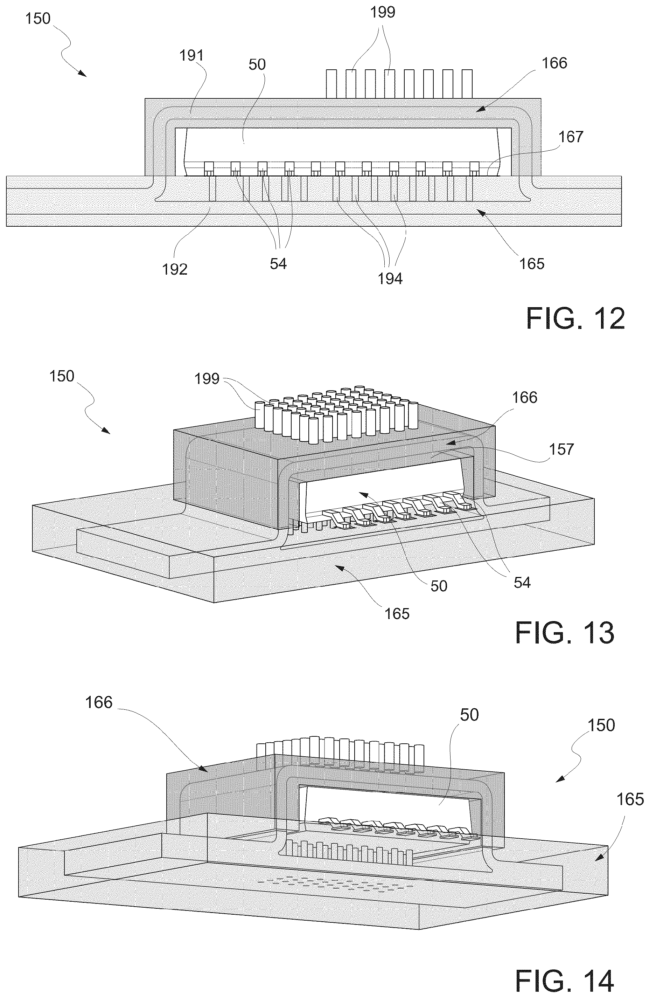

As indicated above, the packaged electronic device 50 is a Double Cooling (DC) device and may be coupled to an external cooling system 150, as for example shown in Figures 12-14.

Here, a lower cooling structure 165 is in contact with the second plate 53 of the second substrate 76 and an upper cooling structure 166 is in contact with the first plate 52 of the first substrate 75.

In the illustrated example, the cooling structures 165 and 166 are of the cooling liquid type, however any type of cooling system suitable for the intended application may be used.

In the example shown, the upper cooling structure 166 has an upper channel 191 for the flow of a cooling fluid; the lower cooling structure 165 in turn has a lower channel 192 for the flow of the cooling fluid.

The channels 191, 192 are also connected to each other upstream and downstream of the packaged electronic device 50.

In the embodiment shown, the upper cooling structure 166 has protrusions 199 to increase the thermal dissipation and the lower cooling structure 165 has small columns 194 that extend between the packaged electronic device 50 and the lower channel 192 and favour heat transfer.

By virtue of the direct contact of the cooling structures 165 and 166 to the substrates 75, 76, very efficient thermal dissipation is obtained.

Finally, it is clear that modifications and variations may be made to the packaged electronic device and to the packaging method described and illustrated herein without thereby departing from the scope of the present invention, as defined in the attached claims.

For example, if not desired, the kelvin pins 54B, 54F and the pin 54C of the first conduction connection element 88C may not be present.

## Claims

1. A packaged electronic device, comprising:
a first support element (75);
a second support element (76), the first and second support elements (75, 76) comprising each a multilayer including a respective first conductive layer (80, 84) facing an inside of the packaged electronic device (50), a second conductive layer (52, 53) arranged facing an outside of the packaged electronic device (50) and an insulating layer (81, 85) interposed between the first and second conductive layers, the first conductive layer (80) of the first support element forming an interconnection region; the first conductive layer (84) of the second support element (76) forming a plurality of islands (89) mutually insulated and including a first and a second island (89G, 89D); the second conductive layer of the first and second support elements (52, 53) forming thermal dissipation plates;
a first die (60) integrating a first electronic component (58) and having a first main face (60A), a second main face (60B), a first, a second and a third contact region (64, 65, 63) on the first main face (60A) of the first die;
a second die (61) integrating a second electronic component (59) and having a first main face (61A), a second main face (61B), a first contact region (69) on the first main face (61A) of the second die and a second contact region (71) on the second main face (61B) of the second die (61), the first and second dice being coupled with the respective first faces (60A, 61A) to the second support element (76) and with the respective second faces (60B, 61B) to the first support element (75), with the second contact region (71) of the second die (61) in electrical contact with the interconnection region (80) of the first support element (75);
a first connection element (88G) including an own internal portion (87G) and an own pin (54G), a second connection element (88D) having an own internal portion (87D) and an own pin (87D), and a third connection element (88C) having an own internal portion (87C); and
a housing (51) embedding the first die (60), the second die (61), the first conductive layer (80, 84) of the first and second support elements (75, 76), the insulating layer (81, 85) of the first and second support elements (75, 76) and the internal portions (87G, 87D, 87C) of the first, second and third connection elements (88G, 88D, 88C), with the first and second pins (54G, 54D) protruding from the housing (51),
wherein the internal portion (87G) of the first connection element (88G) is arranged between the first contact region (64) of the first die (60) and the first island (89G), the internal portion (87D) of the second connection element (88D) is arranged between the first contact region (69) of the second die (61) and the second island (89D); and the internal portion (87C) of the third connection element (88C) has a first section (87C1) coupled to the second contact region (65) of the first die (60) and a second section (87C2) coupled to the interconnection region (80) of the first support element (75).

2. The packaged electronic device according to claim 1, wherein the plurality of islands (89) of the first conductive layer (84) of the second support element (76) comprises a third island (89B-C) and the first section (87C1) of the internal portion (87C) of the third connection element (88C) is arranged between the second contact region (65) of the first die (60) and the third island (89B-C).

3. The packaged electronic device according to claim 1 or 2, wherein the third connection element (88C) comprises a third pin (54C) protruding from the housing (88C).

4. The packaged electronic device according to any of the preceding claims, wherein the first electronic component (58) comprises a first transistor (2) and the second electronic component (59) comprises a second transistor (3); the first and second transistors (2, 3) series-coupled.

5. The packaged electronic device according to the preceding claim, wherein the first transistor (2) is a GaN power transistor.

6. The packaged electronic device according to claim 4 or 5, wherein the second transistor (3) is a low-voltage MOSFET.

7. The packaged electronic device according to any of claims 4-6, wherein the first and second transistors (2, 3) are coupled in cascode configuration, the first contact region (64) of the first die (60) is a drain pad; the second contact region (65) of the first die (60) is a source pad; the first contact region (69) of the second die (61) is a source pad and the second contact region (71) of the second die (61) is a drain pad.

8. The packaged electronic device according to any of claims 4-7, wherein:
the third contact region (63) of the first transistor (58) is a control contact region (63) and the second transistor (59) comprises an own control contact region (68) arranged on the first main face (61A) of the second die (61),
the plurality of islands comprises a fourth island (89A) and a fifth island (89E),
the packaged electronic device (50) further comprises a fourth connection element (88A) and a fifth connection element (88E),
the fourth connection element (88A) having an own internal portion (87A) arranged between the control contact region (63) of the first transistor (58) and an own pin (54A) protruding from the housing (51), and
the fifth connection element (88E) having an own internal portion (87E) arranged between the control contact region (68) of the second transistor (59) and an own pin (54E) protruding from the housing (51).

9. The packaged electronic device according to any of claims 4-8, further comprising a fifth and a sixth connection element (88B, 88F) including an own internal portion (87B, 87F) and an own pin (54B, 54F), the internal portion (87B) of the fifth connection element (88B) coupled to the second contact region (65) of the first die (60) and forming a first Kelvin contact and the internal portion (87F) of the fifth connection element (88F) coupled to the second contact region (69) of the second die (61) and forming a second Kelvin contact.

10. The packaged electronic device according to any of the preceding claims, wherein the second conductive layer (52, 53) of at least one of the first and second support elements (75, 76) has tabs (55) protruding laterally from the housing (51).

11. The packaged electronic device according to any of the preceding claims, wherein the first and second support elements (75, 76) are DBC -Direct Bonded Copper- elements.

12. The packaged electronic device according to any of the preceding claims, wherein the first conductive layer (80, 84) and the second conductive layer (52, 53) of the first and second support elements (75, 76) form thermal vias.

13. The packaged electronic device according to any of the preceding claims, wherein the first die (60) has a substrate (71) in electrical contact with the first conductive layer (80) of the first support element (75).

14. The packaged electronic device according to any of the preceding claims, comprising a first adhesive layer (82) between the first conductive layer (80) of the first support (75) and the second main face (60B, 61B) of the first and second dice (60, 61); a second adhesive layer (90A) between the first main face (60A, 61A) of the first and second dice (60, 61) and the internal portions (87G, 87D) of the first and second connection elements (88G, 88D); and a third adhesive layer (90B) between the internal portions (88G, 87D) of the first and second connection elements (88G, 88D) and the first conductive layer (84) of the second substrate (76).

15. A method of packaging an electronic device, comprising:
bonding a first die (60) to an interconnection region (80) formed by a first conductive layer (80) of a first support (75) formed by a multilayer also including a second conductive layer (52) and an insulating layer (81) interposed between the first and second conductive layers, the first die (60) integrating a first electronic component (58) and having a first main face (60A), a second main face (60B), a first, a second and a third contact region (64, 65, 63) on the first main face (60A) of the first die, the first die (60) being coupled with its second face (60B) to the interconnection region (80) of the first support (75);
bonding a second die (61) to the interconnection region (80) of the first support (75), the second die (61) integrating a second electronic component (59) and having a first main face (61A), a second main face (61B), a first contact region (69) on the first main face (61A) of the second die and a second contact region (71) on the second main face (61B) of the second die (61), the second die coupled with its second face (61B) to the first support element (75), with the second contact region (71) of the second die (61) in electrical contact with the interconnection region (80) of the first support element (75);
bonding an internal portion (87G) of a first connection element (88G) to the first contact region (64) of the first die (60), the first connection element (88G) having an own pin (54G);
bonding an internal portion (87D) of a second connection element (88D) to the first contact region (69) of the second die (61), the second connection element (88D) having an own pin (87D);
bonding a first section (87C1) of an internal portion (87C) of a third connection element (88C) to the second contact region (65) of the first die 60 and a second section (87C2) of the internal portion (87C) of the third connection element (88C) to the interconnection region (80) of the first support (75);
bonding a second support element (76) to the first faces (60A, 61A) of the first and second dice (60, 61), the second support element (76) comprising a multilayer including an own first conductive layer (84), an own second conductive layer (53) and an own insulating layer (85) interposed between the first and second conductive layers of the second support element (76), the first conductive layer (84) of the second support element (76) forming a plurality of islands (89) mutually insulated and including a first and a second island (89G, 89D), the first island (89G) bonded to the internal portion (87G) of the first connection element (88G) and the second island (89D) bonded to the internal portion (87D) of the second connection element (88D); and
forming a housing (51) embedding the first die (60), the second die (61), the first conductive layer (80, 84) of the first and second support elements (75, 76), the insulating layer (81, 85) of the first and second support elements (75, 76) and the internal portions (87G, 87D, 87C) of the first, second and third connection elements (88G, 88D, 88C), with the pins (54G, 54D) of the first and second connection elements (88G, 88D) protruding from the housing (51),
the second conductive layer of the first and second support elements (52, 53) forming thermal dissipation plates.
